# EUROPEAN PATENT APPLICATION

(11) **EP 4 632 319 A1**
(43) Date of publication of application: **15.10.2025**
(21) Application number: 25166603.8
(22) Date of filing: 27.03.2025
(51) Int. Cl.: G01B 21/20, B21B 1/40, G01B 21/30

(54) **A APPARATUS FOR MEASURING A METAL PLATE, A METHOD OF MEASURING, AND A METHOD OF MANUFACTURING A METAL PLATE**

(30) Priority: 11.04.2024 JP 2024064215
(71) Applicant: Dai Nippon Printing Co., Ltd., Tokyo 162-8001 (JP)
(72) Inventor: NAKAMURA, Yusuke, TOKYO, 1628001 (JP); ISHIKAWA, Goro, TOKYO, 1628001 (JP); YANO, Hiroshi, TOKYO, 1628001 (JP); OKA, Hiroki, TOKYO, 1628001 (JP); NUMATA, Hiroshi, TOKYO, 1628001 (JP)
(74) Representative: Müller-Boré & Partner Patentanwälte PartG mbB

(57) **Abstract**

A device for measuring a metal plate, a measuring method, and a method for manufacturing a metal plate that enable continuous measurement of a surface shape of a metal plate in a wider range are provided. The device for measuring a metal plate includes a transfer mechanism that transfers the metal plate in a longitudinal direction D2, a sensor that measures a surface shape of a first surface of the metal plate, a stage with which a second surface of the metal plate positioned opposite to the first surface comes into contact during measurement by the sensor, and a control unit that repeatedly executes a first step, a second step, and a third step. In the first step, the metal plate is transferred by the transfer mechanism in a state where the metal plate is not in contact with the stage. In the second step, transfer of the metal plate is stopped, and the second surface of the metal plate, transfer of which is stopped, is brought into contact with the stage. In the third step, the surface shape of the first surface of the metal plate is measured by the sensor in a state where the second surface of the metal plate is in contact with the stage. The stage has a hole or a groove in a surface with which the metal plate comes into contact.

## Description

### BACKGROUND OF THE INVENTION

### Field of the Invention

The present invention relates to a device for measuring a metal plate, a measuring method, and a method for manufacturing a metal plate.

### Description of the Related Art

In recent years, display devices used in portable devices such as smartphones and tablet PCs have been required to be high-definition, for example, required to have a pixel density of 500 ppi or more. A demand for portable devices to be compatible with ultra-high definition (UHD) has also been increased. In this case, display devices preferably have a pixel density of 800 ppi or more, for example.

Among display devices, organic EL display devices are receiving attention because of their good responsiveness, low power consumption, and high contrast. Known as a method for forming pixels of an organic EL display device is a method for forming pixels in a desired pattern using a metal mask in which through-holes arrayed in the desired pattern have been formed. Specifically, the metal mask is first brought into close contact with a substrate for an organic EL display device. Next, the metal mask and the substrate in close contact with each other are input together to a vapor deposition device, and a vapor deposition step of vapor-depositing an organic material on the substrate is performed. Pixels containing the organic material can thereby be formed on the substrate in a pattern corresponding to the pattern of through-holes in the metal mask.

Known as a method for manufacturing a metal mask is a method for forming through-holes in a metal plate by etching through use of the photolithography technology. For example, a first resist pattern is first formed on a first surface of a metal plate through exposure and development treatment, and a second resist pattern is formed on a second surface of the metal plate through exposure and development treatment. Next, a region of the first surface of the metal plate which is not covered by the first resist pattern is etched to form a first recess in the first surface of the metal plate. Thereafter, a region of the second surface of the metal plate which is not covered by the second resist pattern is etched to form a second recess in the second surface of the metal plate. On this occasion, etching is performed such that the first recess and the second recess communicate with each other. Through-holes extending through the metal plate can thereby be formed.

A metal plate for producing a metal mask is produced by rolling a base material made of an iron alloy containing nickel, for example. Pixels of the metal mask obtained are improved in dimensional accuracy and positional accuracy as the metal plate is rolled more thinly. However, on the other hand, a noticeable wavy shape may appear in the metal plate due to rolling. Appearance of such a wavy shape might degrade the positional accuracy and dimensional accuracy of through-holes to be formed in the metal plate.

Therefore, it is important to evaluate the wavy shape of the metal plate from a viewpoint of quality assurance of the metal plate. The metal plate obtained by rolling is very elongated. Therefore, from the viewpoint of quality assurance of the overall metal plate, it is preferable to evaluate the wavy shape of the metal plate in a wider range.

However, a conventional measurement device for the wavy shape of a metal plate is to measure, in a sheet form, a measurement sample cut out from the metal plate. Therefore, it is difficult to evaluate the wavy shape of the metal plate in a wide range.

In a case of performing the etching process through use of the photolithography technology for a roll of the metal plate, cutting out a measurement sample from an intermediate portion of the roll of the metal plate cut off the roll itself, which significantly affects the etching process. Therefore, in this case, a measurement sample is cut out from a leading end of the roll of the metal plate. Consequently, it is difficult with the conventional sheet-form measurement device to evaluate the wavy shape in a wide range including the intermediate portion of the roll of the metal plate.

The present invention has been made in view of the above-described problems and has an object to provide a device for measuring a metal plate, a measuring method, and a method for manufacturing a metal plate that enable continuous measurement of a surface shape of the metal plate in a wider range.

### SUMMARY OF THE INVENTION

A device for measuring a metal plate according to one embodiment of the present disclosure includes:
a transfer mechanism that transfers the metal plate in a longitudinal direction D2;
a sensor that measures a surface shape of a first surface of the metal plate;
a stage with which a second surface of the metal plate positioned opposite to the first surface comes into contact during measurement by the sensor; and
a control unit that repeatedly executes a first step, a second step, and a third step, in which
   in the first step, the metal plate is transferred by the transfer mechanism in a state where the metal plate is not in contact with the stage,
   in the second step, transfer of the metal plate is stopped, and the second surface of the metal plate, transfer of which is stopped, is brought into contact with the stage,
   in the third step, the surface shape of the first surface of the metal plate is measured by the sensor in a state where the second surface of the metal plate is in contact with the stage, and
   the stage has a hole or a groove in a surface with which the metal plate comes into contact.

A method for measuring a metal plate according to one embodiment of the present disclosure is performed using a measurement device including
a transfer mechanism that transfers the metal plate in a longitudinal direction D2,
   a sensor that measures a surface shape of a first surface of the metal plate,
   a stage with which a second surface of the metal plate positioned opposite to the first surface comes into contact during measurement by the sensor, and
   a control unit that repeatedly executes a first step, a second step, and a third step, in which
in the first step, the metal plate is transferred by the transfer mechanism in a state where the metal plate is not in contact with the stage,
in the second step, transfer of the metal plate is stopped, and the second surface of the metal plate, transfer of which is stopped, is brought into contact with the stage,
in the third step, the surface shape of the first surface of the metal plate is measured by the sensor in a state where the second surface of the metal plate is in contact with the stage, and
the stage has a hole or a groove in a surface with which the metal plate comes into contact.

A method for manufacturing a metal plate to be used for manufacturing a metal mask according to one embodiment of the present disclosure, the method including:
a rolling step of rolling a base material to obtain the metal plate; and
an inspection step of inspecting the metal plate having been rolled, in which
the inspection step is performed using a measurement device including
   a transfer mechanism that transfers the metal plate in a longitudinal direction D2,
   a sensor that measures a surface shape of a first surface of the metal plate,
   a stage with which a second surface of the metal plate positioned opposite to the first surface comes into contact during measurement by the sensor, and
   a control unit that repeatedly executes a first step, a second step, and a third step,
in the first step, the metal plate is transferred by the transfer mechanism in a state where the metal plate is not in contact with the stage,
in the second step, transfer of the metal plate is stopped, and the second surface of the metal plate, transfer of which is stopped, is brought into contact with the stage,
in the third step, the surface shape of the first surface of the metal plate is measured by the sensor in a state where the second surface of the metal plate is in contact with the stage, and
the stage has a hole or a groove in a surface with which the metal plate comes into contact.

A method for manufacturing a metal mask in which a plurality of through-holes are formed according to one embodiment of the present disclosure, the method including:
a step of preparing a metal plate;
a resist pattern forming step of forming a resist pattern on the metal plate; and
an etching step of etching a region of the metal plate which is not covered by the resist pattern to form, in the metal plate, recesses to serve to define the through-holes, in which
the step of preparing a metal plate is performed using a measurement device including
   a transfer mechanism that transfers the metal plate in a longitudinal direction D2,
   a sensor that measures a surface shape of a first surface of the metal plate,
   a stage with which a second surface of the metal plate positioned opposite to the first surface comes into contact during measurement by the sensor, and
   a control unit that repeatedly executes a first step, a second step, and a third step,
in the first step, the metal plate is transferred by the transfer mechanism in a state where the metal plate is not in contact with the stage,
in the second step, transfer of the metal plate is stopped, and the second surface of the metal plate, transfer of which is stopped, is brought into contact with the stage,
in the third step, the surface shape of the first surface of the metal plate is measured by the sensor in a state where the second surface of the metal plate is in contact with the stage, and
the stage has a hole or a groove in a surface with which the metal plate comes into contact.

### Advantageous Effects of the Invention

According to the present invention, a device for measuring a metal plate, a measuring method, and a method for manufacturing a metal plate that enable continuous measurement of a surface shape of the metal plate in a wider range can be provided.

### BRIEF DESCRIPTION OF THE DRAWINGS

FIG. 1 is a perspective view representing an example of a device for measuring a metal plate of the present disclosure;
FIG. 2A is a plan view representing a moving aspect of a sensor when a stage is seen in plan view;
FIG. 2B is a plan view representing a moving aspect of the sensor when the stage is seen in plan view;
FIG. 2C is a plan view representing a moving aspect of the sensor when the stage is seen in plan view;
FIG. 2D is a plan view representing an aspect of measuring a surface by the sensor while intermittently moving the metal plate;
FIG. 3A is a perspective view showing an aspect of the stage;
FIG. 3B is a perspective view showing an aspect of the stage;
FIG. 3C is a perspective view showing an aspect of the stage;
FIG. 4A is an outlined cross-sectional view showing an aspect of first to third steps;
FIG. 4B is an outlined cross-sectional view showing an aspect of the second step performed using a tension adjustment mechanism;
FIG. 4C is an outlined cross-sectional view showing an aspect of the second step performed using the tension adjustment mechanism;
FIG. 4D is an outlined cross-sectional view showing an aspect of the second step performed using the tension adjustment mechanism;
FIG. 4E is an outlined cross-sectional view showing an aspect of the second step performed using a lifting and lowering mechanism;
FIG. 4F is an outlined cross-sectional view showing an aspect of the second step performed using a lifting and lowering mechanism;
FIG. 5 is a flowchart representing an aspect of a method for measuring the metal plate;
FIG. 6A is an outlined cross-sectional view showing an aspect of a rolling step;
FIG. 6B is an outlined cross-sectional view showing an aspect of an annealing step;
FIG. 7A is an outlined schematic view for describing an example of a method for manufacturing a metal mask;
FIG. 7B is a diagram showing an example of a step of forming a resist film on a metal plate;
FIG. 7C is a diagram showing an example of a step of patterning the resist film;
FIG. 7D is a diagram showing an example of a first surface etching step;
FIG. 7E is a diagram showing an example of a second surface etching step;
FIG. 8 is a diagram showing a metal mask device according to an embodiment of the present disclosure; and
FIG. 9 is a cross-sectional view showing a vapor deposition device according to an embodiment of the present disclosure.

### DETAILED DESCRIPTION OF THE PREFERRED EMBODIMENT

Hereinafter, an embodiment of the present disclosure will be described with reference to the drawings. Note that in the drawings attached to the present specification, for convenience of ease of depiction and understanding, scale ratios, longitudinal and lateral dimensional ratios, and the like are exaggerated as appropriate by changing them from actual ones in some cases.

In the present specification and/or the present drawings, interpretation will be made as indicated below unless particularly described.

Terms that mean a substance on which a certain component is based may not be distinguished from each other only based on different names. For example, terms such as a "substrate", a "base material", a "plate", a "sheet", and a "film" are relevant to the above description.

Terms and/or numerals that mean shapes and/or geometric conditions are not necessarily limited to their strict definitions, but may be construed to include a range to a degree that similar functions may be expected. For example, terms such as "parallel" and/or "orthogonal" are relevant to the above-described terms. Values such as "values of length" and/or "values of angle" are relevant to the above-described numerals.

In some cases where a component is expressed as being "on", "under", "on an upper side of", "on a lower side of", "above", or "below" another component, the cases may include an aspect in which the component is in direct contact with the other component, and an aspect in which a different component is included between the component and the other component. In other words, the aspect in which a different component is included between the component and the other component may be expressed as the component and the other component being in indirect contact with each other. The expression "on", "upper side", or "above" can be exchanged to the expression "under", "lower side", or "below". In other words, an up-down direction may be reversed.

Identical portions and/or portions that have a similar function are designated by identical reference characters or like reference characters, and repeated description is omitted in some cases. The ratio of dimensions in the drawings differs from an actual ratio in some cases. Illustration of some components of an embodiment is omitted in the drawings in some cases.

One or more embodiments and one or more modifications may be combined within a range where no contradiction occurs. One or more embodiments may be combined within a range where no contradiction occurs. One or more modifications may be combined within a range where no contradiction occurs.

In a case where a plurality of steps are disclosed in relation to a method such as a manufacturing method, another undisclosed step may be performed between the disclosed steps. The order of the steps is not limited within a range where no contradiction occurs.

A numeral range expressed by the word "to" includes numerals placed in front of and behind the word "to". For example, a numeral range expressed as "34 to 38 mass %" is identical to a numeral range expressed as "34 mass % or more and 38 mass % or less".

A numeral range of a numeral described in the present disclosure may be defined by combining an arbitrary one of a plurality of upper-limit candidate values and an arbitrary one of a plurality of lower-limit candidate values. Besides, any two of the plurality of upper-limit candidate values may be combined to define the numeral range, or any two of the plurality of lower-limit candidate values may be combined to define the numeral range without particular mention.

One embodiment of the present disclosure will be described in the following paragraphs. One embodiment of the present disclosure is an example of embodiments of the present disclosure. The present disclosure is not construed as being limited only to the one embodiment of the present disclosure.

A first aspect of the present disclosure is a device for measuring a metal plate, the device including:
a transfer mechanism that transfers the metal plate in a longitudinal direction D2;
a sensor that measures a surface shape of a first surface of the metal plate;
a stage with which a second surface of the metal plate positioned opposite to the first surface comes into contact during measurement by the sensor; and
a control unit that repeatedly executes a first step, a second step, and a third step, in which
   in the first step, the metal plate is transferred by the transfer mechanism in a state where the metal plate is not in contact with the stage,
   in the second step, transfer of the metal plate is stopped, and the second surface of the metal plate, transfer of which is stopped, is brought into contact with the stage,
   in the third step, the surface shape of the first surface of the metal plate is measured by the sensor in a state where the second surface of the metal plate is in contact with the stage, and
   the stage has a hole or a groove in a surface with which the metal plate comes into contact.

In a second aspect of the present disclosure, the device of the first aspect described above further includes a tension adjustment mechanism that adjusts tension on the metal plate in the longitudinal direction D2, in which
the control unit exerts control so as to
in the first step, adjust the tension on the metal plate by the tension adjustment mechanism such that the metal plate does not come into contact with the stage and transfer the metal plate by the transfer mechanism,
in the third step, stop transfer of the metal plate, adjust the tension on the metal plate by the tension adjustment mechanism such that the metal plate comes into contact with the stage, and measure the surface shape of the first surface of the metal plate by the sensor.

In a third aspect of the present disclosure, the device of the first aspect or the second aspect described above further includes a lifting and lowering mechanism that relatively lifts and lowers the transfer mechanism relative to the stage, in which
the control unit exerts control so as to
in the first step, adjust an interval between the metal plate and the stage by the lifting and lowering mechanism such that the metal plate and the stage do not come into contact with each other and transfer the metal plate by the transfer mechanism, and
in the third step, stop transfer of the metal plate, adjust the interval between the metal plate and the stage by the lifting and lowering mechanism such that the metal plate and the stage come into contact with each other, and measure the surface shape of the first surface of the metal plate by the sensor.

In a fourth aspect of the present disclosure, the device of any of the first to third aspects described above further includes at least one of a tension adjustment mechanism that adjusts tension on the metal plate in the longitudinal direction D2 and a lifting and lowering mechanism that relatively lifts and lowers the transfer mechanism relative to the stage, in which
the control unit exerts control so as to
in the first step, adjust the tension on the metal plate and/or the interval between the metal plate and the stage by the tension adjustment mechanism and/or the lifting and lowering mechanism such that the metal plate does not come into contact with the stage and transfer the metal plate by the transfer mechanism, and
in the third step, stop transfer of the metal plate, adjust the tension on the metal plate and/or the interval between the metal plate and the stage by the tension adjustment mechanism and/or the lifting and lowering mechanism such that the metal plate comes into contact with the stage, and measure the surface shape of the first surface of the metal plate by the sensor.

In a fifth aspect of the present disclosure, in the device of any of the first to fourth aspects described above, the metal plate has a thickness of 5 to 100 µm.

In a sixth aspect of the present disclosure, in the device of any of the first to fifth aspects described above, a contactable area is 80% to 99%.

In a seventh aspect of the present disclosure, in the device of any of the first to sixth aspects described above, the transfer mechanism has a first roll that feeds the metal plate and a second roll that rolls up the metal plate.

An eighth aspect of the present disclosure is a method for measuring a metal plate, which is performed using a measurement device including
a transfer mechanism that transfers the metal plate in a longitudinal direction D2,
   a sensor that measures a surface shape of a first surface of the metal plate,
   a stage with which a second surface of the metal plate positioned opposite to the first surface comes into contact during measurement by the sensor, and
   a control unit that repeatedly executes a first step, a second step, and a third step, in which
in the first step, the metal plate is transferred by the transfer mechanism in a state where the metal plate is not in contact with the stage,
in the second step, transfer of the metal plate is stopped, and the second surface of the metal plate, transfer of which is stopped, is brought into contact with the stage,
in the third step, the surface shape of the first surface of the metal plate is measured by the sensor in a state where the second surface of the metal plate is in contact with the stage, and
the stage has a hole or a groove in a surface with which the metal plate comes into contact.

A ninth aspect of the present disclosure is a method for manufacturing a metal plate to be used for manufacturing a metal mask, the method including:
a rolling step of rolling a base material to obtain the metal plate; and
an inspection step of inspecting the metal plate having been rolled, in which
the inspection step is performed using a measurement device including
   a transfer mechanism that transfers the metal plate in a longitudinal direction D2,
   a sensor that measures a surface shape of a first surface of the metal plate,
   a stage with which a second surface of the metal plate positioned opposite to the first surface comes into contact during measurement by the sensor, and
   a control unit that repeatedly executes a first step, a second step, and a third step,
in the first step, the metal plate is transferred by the transfer mechanism in a state where the metal plate is not in contact with the stage,
in the second step, transfer of the metal plate is stopped, and the second surface of the metal plate, transfer of which is stopped, is brought into contact with the stage,
in the third step, the surface shape of the first surface of the metal plate is measured by the sensor in a state where the second surface of the metal plate is in contact with the stage, and
the stage has a hole or a groove in a surface with which the metal plate comes into contact.

A tenth aspect of the present disclosure is a method for manufacturing a metal mask in which a plurality of through-holes are formed, the method including:
a step of preparing a metal plate;
a resist pattern forming step of forming a resist pattern on the metal plate; and
an etching step of etching a region of the metal plate which is not covered by the resist pattern to form, in the metal plate, recesses to serve to define the through-holes, in which
the step of preparing a metal plate is performed using a measurement device including
   a transfer mechanism that transfers the metal plate in a longitudinal direction D2,
   a sensor that measures a surface shape of a first surface of the metal plate,
   a stage with which a second surface of the metal plate positioned opposite to the first surface comes into contact during measurement by the sensor, and
   a control unit that repeatedly executes a first step, a second step, and a third step,
in the first step, the metal plate is transferred by the transfer mechanism in a state where the metal plate is not in contact with the stage,
in the second step, transfer of the metal plate is stopped, and the second surface of the metal plate, transfer of which is stopped, is brought into contact with the stage,
in the third step, the surface shape of the first surface of the metal plate is measured by the sensor in a state where the second surface of the metal plate is in contact with the stage, and
the stage has a hole or a groove in a surface with which the metal plate comes into contact.

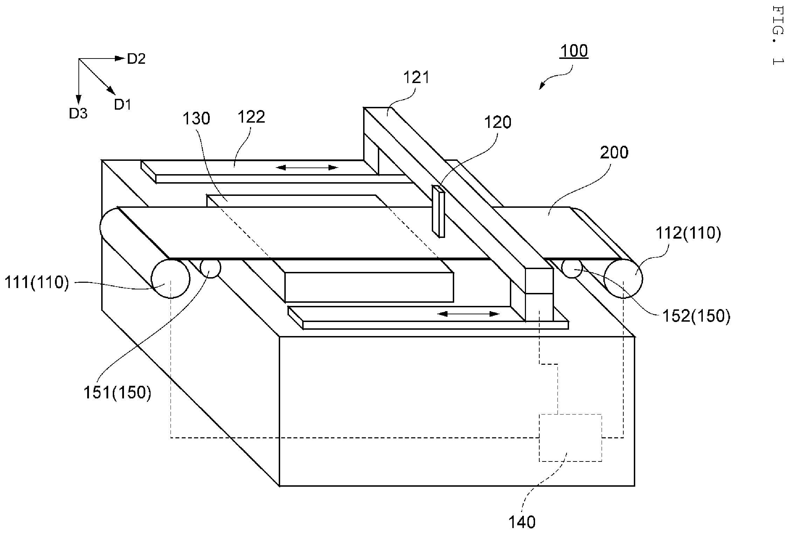

FIG. 1 shows a perspective view representing an example of a device for measuring a metal plate of the present disclosure. A device 100 for measuring a metal plate of the present disclosure has a transfer mechanism 110 that transfers a metal plate 200 in a longitudinal direction D2, a sensor 120 that measures a surface shape of a first surface 210 of the metal plate 200, a stage 130 with which a second surface 220 of the metal plate 200 positioned opposite to the first surface 210 comes into contact during measurement by the sensor 120, and a control unit 140.

The control unit 140 controls a tension adjustment mechanism 150, a lifting and lowering mechanism 160, and the like which will be described later in addition to the transfer mechanism 110 and the sensor 120, thereby repeatedly executing a first step S1, a second step S2, and a third step S3.

Although details of the steps will be described later, in the first step S1, the metal plate 200 is transferred by the transfer mechanism 110 in a state where the metal plate 200 is not in contact with the stage 130. In the second step S2, transfer of the metal plate 200 is stopped, and the second surface 220 of the metal plate 200, transfer of which is stopped, is brought into contact with the stage 130. In the third step S3, the surface shape of the first surface 210 of the metal plate 200 is measured by the sensor 120 in a state where the second surface 220 of the metal plate 200 is in contact with the stage 130. This enables continuous measurement of the surface shape of the metal plate in a wider range.

The transfer mechanism 110 transfers the metal plate 200 in the longitudinal direction D2. The transfer mechanism 110 may have, for example, a first roll 111 that feeds the metal plate 200 and a second roll 112 that rolls up the metal plate 200. By feeding the metal plate 200 from the first roll 111 and rolling up the metal plate 200 into the second roll 112 in response to instructions from the control unit 140, the transfer mechanism 110 can transfer the metal plate 200 in the longitudinal direction D2 and stop transfer of the metal plate 200.

The transfer mechanism 110 may have a first supplementary roll 151 and a second supplementary roll 152 between the first roll 111 and the second roll 112. The first supplementary roll 151 and the second supplementary roll 152 may support the metal plate 200 between the first roll 111 and the second roll 112 and perform transfer assistance for feeding and rolling up the metal plate 200. The transfer mechanism 110 not only has the rolls shown in FIG. 1, but may also have another roll that contributes to transfer.

The sensor 120 measures the surface shape of the first surface 210 of the metal plate 200. A surface state measured by the sensor 120 may include information concerning the height of the surface of the first surface 210 of the metal plate 200. The information concerning the height is also referred to as a "height profile". This height profile may be data that three-dimensionally represents the surface shape of the first surface 210 of the metal plate 200 and may include, for example, each position on the plane formed by a width direction D1 and the longitudinal direction D2 of the metal plate 200 and information concerning the height of the surface of the metal plate 200 in a height direction D3 for each position in association with each other.

The wavy shape on the surface of the first surface 210 can be represented by the height profile thus acquired by the sensor 120. The degree of steepness, the differential expansion rate, and the like in the width direction D1, the longitudinal direction D2, or another arbitrary direction can also be calculated based on such a height profile.

The sensor 120 is not particularly restricted as long as the surface shape of the first surface 210 of the metal plate 200 can be measured, and examples thereof can include an optical displacement sensor and a pressure displacement sensor. The height profile can be measured by measuring the distance between the sensor 120 and the first surface 210.

As the optical displacement sensor, a conventionally known one can be used. An example thereof can be a triangulation displacement sensor that irradiates a target object with light different in focus position depending on the wavelength to measure the height of the target object in accordance with an image forming position of reflected light of the light with which the target object is irradiated, a white light coaxial confocal displacement sensor that detects a wavelength position of a maximum light amount from a received spectrum to measure the height of the target object, or the like.

At least one of the sensor 120 and the stage 130 may be configured to be movable relative to each other. A device configuration shown in FIG. 1, the stage 130 remains at rest, and the sensor 120 is configured to be movable relative to the stage 130. Specifically, the sensor 120 may be configured to be movable in the width direction D1 by means of the first moving mechanism 121. The first moving mechanism 121 may be configured to be movable in the longitudinal direction D2 by means of the second moving mechanism 122. This enables the sensor 120 to move also on the plane formed by the width direction D1 and the longitudinal direction D2. At this time, the first moving mechanism 121 and the second moving mechanism 122 may have mechanisms that acquire coordinates in the width direction D1 and the longitudinal direction D2, respectively. Accordingly, when information concerning the height is measured by the sensor 120, the value of the height and coordinates on the plane formed by the width direction D1 and the longitudinal direction D2 may be recorded in association with each other. The mechanisms that acquire the coordinates can include, for example, but are not particularly limited to, an encoder and a laser interferometer. In addition, the first moving mechanism 121 may be configured to be able to move the sensor 120 in the height direction D3. The sensor 120 is thereby movable also in the height direction D3 in addition to the planar direction. Note that instead of this, the sensor 120 may be fixed, and the stage 130 may be configured to be movable.

By moving the stage 130 in the width direction D1 and the longitudinal direction D2, information concerning the height of the surface of the first surface 210 of the metal plate 200 may be measured while moving the sensor 120 and the metal plate 200 relatively in the width direction D1 and the longitudinal direction D2. In this case, the measurement device 100 may have a mechanism that controls driving of the stage 130 while acquiring coordinates in the width direction D1 and the longitudinal direction D2. The coordinates in the directions D1 and D2 at a position where the height has been measured by the sensor 120 may thereby be recorded. Herein, the mechanism that acquires the coordinates can include, for example, but is not particularly limited to, an encoder and a laser interferometer.

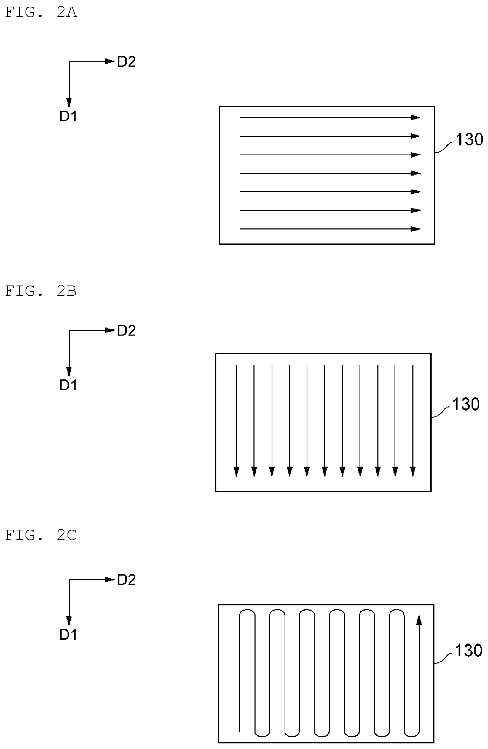

FIG. 2A to FIG. 2C show examples of a moving aspect of the sensor 120 when the stage 130 is seen in plan view. In FIG. 2A to FIG. 2C, the direction in which the stage 130 is scanned with the sensor 120 measuring the surface shape of the first surface 210 is indicated by arrows. FIG. 2A to FIG. 2C do not show a path along which the sensor 120 in a state not performing measurement is moved. FIG. 2A and FIG. 2B show aspects in which the stage 130 is scanned in one direction with the sensor 120 measuring the surface shape of the first surface 210 in the width direction D1 or the longitudinal direction D2. FIG. 2C shows an aspect in which the stage 130 is repeatedly scanned in both directions in the width direction D1 with the sensor 120 being moved. The moving aspect of the sensor 120 is not limited to those described above.

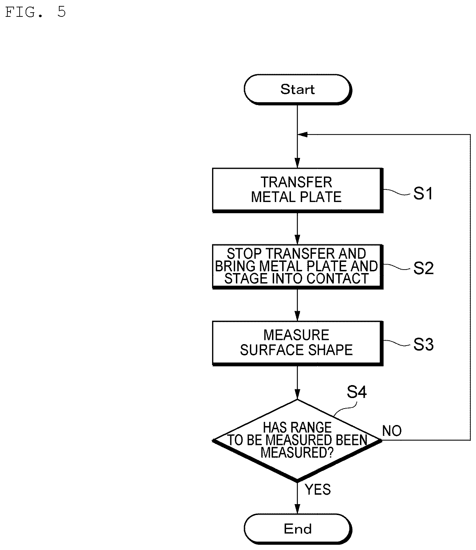

As described above, the planar coordinates in the width direction D1 and the longitudinal direction D2 and the information concerning the height of the metal plate 200 at each coordinate position can be measured while relatively moving the sensor 120 and the stage 130, and can be recorded in association with each other. As illustrated in FIG. 2A to FIG. 2C, a three-dimensional profile which is the surface shape can be obtained over a large part of the roll of the metal plate 200 by repeating measurement in a predetermined region of the metal plate 200 on the stage 130 at regular intervals and intermittently moving the metal plate 200 to repeat measurement in the length direction of the metal plate 200 as shown in FIG. 5 which will be described later.

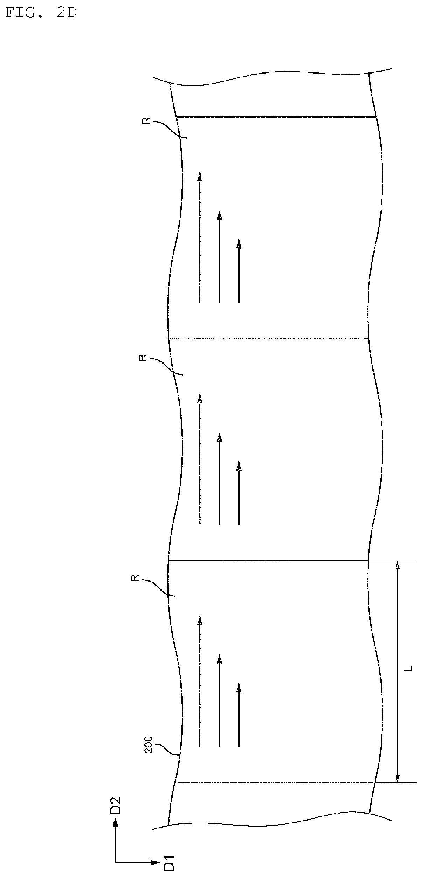

FIG. 2D shows an outlined view of the above-described movement and measurement. FIG. 2D shows an aspect of moving the sensor 120 in each measurement region R to measure the surface shape of the first surface 210 and intermittently moving the metal plate 200 by a distance L so that the region R targeted for measurement is sequentially moved to measure a three-dimensional profile which is the surface shape over a large part of the roll of the metal plate 200. Arrows shown in the regions R indicate that the stage 130 is scanned by the sensor 120 in the longitudinal direction D2 as shown in FIG. 2A to measure a three-dimensional profile in each of the measurement regions R.

The stage 130 is a portion with which the second surface 220 of the metal plate 200 positioned opposite to the first surface 210 comes into contact during measurement by the sensor 120. The metal plate 200 is, for example, a metal plate as thin as approximately 20 µm. From a viewpoint of correctly measuring the surface shape of such a metal plate 200, the present disclosure brings the second surface 220 of the metal plate 200, transfer of which is stopped, into contact with the stage 130 (the second step S2), and measures the surface shape of the first surface 210 of the metal plate 200 by the sensor 120 in the state where the second surface 220 of the metal plate 200 is in contact with the stage 130 (the third step S3).

As an example, the metal plate 200 is 500 mm in width, approximately 20 µm in thickness, large-sized, thin, and light. Thus, when the second surface 220 of the metal plate 200, transfer of which is stopped, is brought into contact with the stage 130, it may be difficult to push away air between the stage 130 and the metal plate 200 by the weight of the metal plate 200 itself. The presence of air between the stage 130 and the metal plate 200 leads to incorrect measurement of the surface shape of the first surface 210. Thus, it is required to wait for the air to escape before measurement of the surface shape of the first surface 210. In terms of improving the measuring speed and measuring the metal plate 200 in a wider range, a shorter waiting time is preferable.

Therefore, the stage 130 may have holes or grooves in the surface with which the metal plate 200 comes into contact. The holes or grooves may function as a passage that allows air between the stage 130 and the metal plate 200 to escape. This can further improve the measuring speed. The presence of the holes or grooves also facilitates reduction of vibration of the metal plate 200 when the stage 130 and the metal plate 200 come into contact with each other, which leads to a tendency that the measurement accuracy is further improved.

The shape of the holes is not particularly limited and may be circular or polygonal, for example. The cross-sectional shape of the holes or grooves is not particularly limited and may have an identical width in cross section, may be broadened like a V-shape toward the surface with which the metal plate comes into contact, or may be narrowed toward the surface with which the metal plate comes into contact. The holes or grooves may or may not extend through the stage.

A contactable area of the stage 130 preferably may be 80% to 99%, may be 85% to 99%, or may be 90% to 98%. The contactable area falling within the above-described range facilitates reduction of vibration of the metal plate 200 when the stage 130 and the metal plate 200 come into contact with each other, which leads to a tendency that the measurement accuracy is further improved and that the measuring speed is further improved.

Note that herein, the "contactable area" refers to a ratio of an area that can be brought into contact with the metal plate 200 excluding the holes or grooves to the entire surface of the stage 130 when the stage 130 is seen in plan view. Consequently, in a case where holes or grooves of 500 cm² in total are formed in the stage 130 of 2500 cm² when seen in plan view, for example, the contactable area will be 80% ((2500-500) / 2500 × 100).

It is favorable that the stage 130 should have high flatness in terms of the measurement accuracy. Examples thereof include glass, resin, ceramic, and the like. A stone surface plate is preferable because of seldom changing in shape over time and having high scratch resistance. It is more preferable to use a Grade 0 or Grade 00 surface plate according to JIS B 7513 in terms of the flatness. Herein, Grade 0 refers to a surface plate having a tolerance value of 5 µm or less for the flatness of the entire surface when a used surface has dimensions of 630 mm × 630 mm, and Grade 00 refers to a surface plate having a tolerance value of 2.5 µm or less for the flatness of the entire surface when a used surface has dimensions of 630 mm × 630 mm.

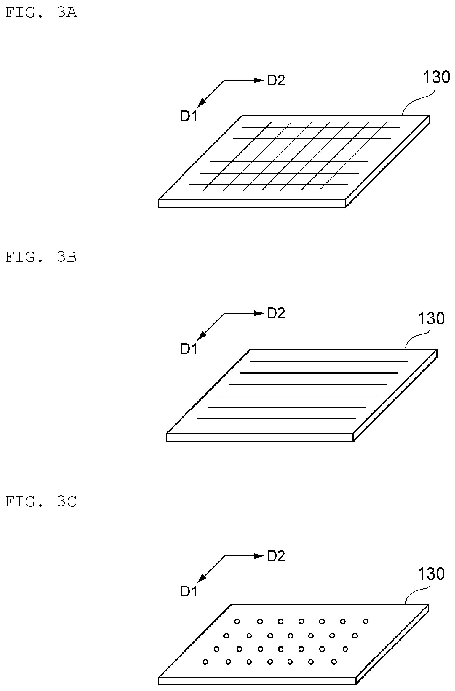

FIG. 3A to FIG. 3C show perspective views of the stage 130. FIG. 3A shows a perspective view of a stage having grooves in the width direction D1 and the longitudinal direction D2. FIG. 3B shows a perspective view of a stage having grooves in the longitudinal direction D2. Instead, the stage may have grooves in the width direction D1. FIG. 3C shows a perspective view of a stage having holes arrayed in the width direction D1 and the longitudinal direction D2. Configuration examples of holes and grooves are not limited to those described above, and holes and grooves may be combined.

A width of the grooves or a diameter of the holes preferably may be 0.1 mm or more, may be 0.2 mm or more, may be 0.3 mm or more, may be 0.4 mm or more, may be 0.5 mm or more, or may be 0.6 mm or more. The width of the grooves or the diameter of the holes preferably may be 30 mm or less, may be 20 mm or less, may be 10 mm or less, may be 5 mm or less, may be 3 mm or less, or may be 2 mm or less. The width of the grooves or the diameter of the holes may be determined by a combination of an arbitrary one of the above-described plurality of lower-limit candidate values and an arbitrary one of the above-described plurality of upper-limit candidate values. For example, the width of the grooves or the diameter of the holes preferably may be 0.1 to 30 mm or less, may be 0.2 to 20 mm or less, may be 0.3 to 10 mm or less, may be 0.4 to 5 mm or less, or may be 0.5 to 3 mm or less.

The width of the grooves or the diameter of the holes preferably is shorter than a measurement pitch which will be described later. A ratio of the width of the grooves or the diameter of the holes to the measurement pitch preferably may be 0.1 or more, may be 0.2 or more, may be 0.3 or more, or may be 0.4 or more. The ratio of the width of the grooves or the diameter of the holes to the measurement pitch preferably may be less than 1.0, may be 0.9 or less, may be 0.8 or less, or may be 0.7 or less. The ratio of the width of the grooves or the diameter of the holes to the measurement pitch may be determined by a combination of an arbitrary one of the above-described plurality of lower-limit candidate values and an arbitrary one of the above-described plurality of upper-limit candidate values. For example, the ratio of the width of the grooves or the diameter of the holes to the measurement pitch may be 0.1 to 0.9, may be 0.2 to 0.8, or may be 0.3 to 0.7.

A depth of the grooves or the holes preferably may be 0.1 mm or more, may be 0.2 mm or more, may be 0.3 mm or more, may be 0.4 mm or more, may be 0.5 mm or more, or may be 0.6 mm or more. The width of the grooves or the diameter of the holes preferably may be 30 mm or less, may be 20 mm or less, may be 10 mm or less, may be 5 mm or less, may be 3 mm or less, or may be 2 mm or less. The depth of the grooves or the holes may be determined by a combination of an arbitrary one of the above-described plurality of lower-limit candidate values and an arbitrary one of the above-described plurality of upper-limit candidate values. For example, the depth of the grooves or the holes preferably may be 0.1 to 30 mm or less, may be 0.2 to 20 mm or less, may be 0.3 to 10 mm or less, may be 0.4 to 5 mm or less, or may be 0.5 to 3 mm or less.

A pitch of the grooves or a spacing distance between adjacent ones of the holes preferably may be 1 mm or more, may be 5 mm or more, may be 10 mm or more, may be 20 mm or more, may be 30 mm or more, or may be 40 mm or more. The pitch of the grooves or the spacing distance between adjacent ones of the holes preferably may be 200 mm or less, may be 175 mm or less, may be 150 mm or less, may be 125 mm or less, may be 100 mm or less, or may be 75 mm or less. The pitch of the grooves or the spacing distance between adjacent ones of the holes may be determined by a combination of an arbitrary one of the above-described plurality of lower-limit candidate values and an arbitrary one of the above-described plurality of upper-limit candidate values. For example, the pitch of the grooves or the spacing distance between adjacent ones of the holes preferably may be 1 to 200 mm or less, may be 5 to 150 mm or less, or may be 10 to 100 mm or less.

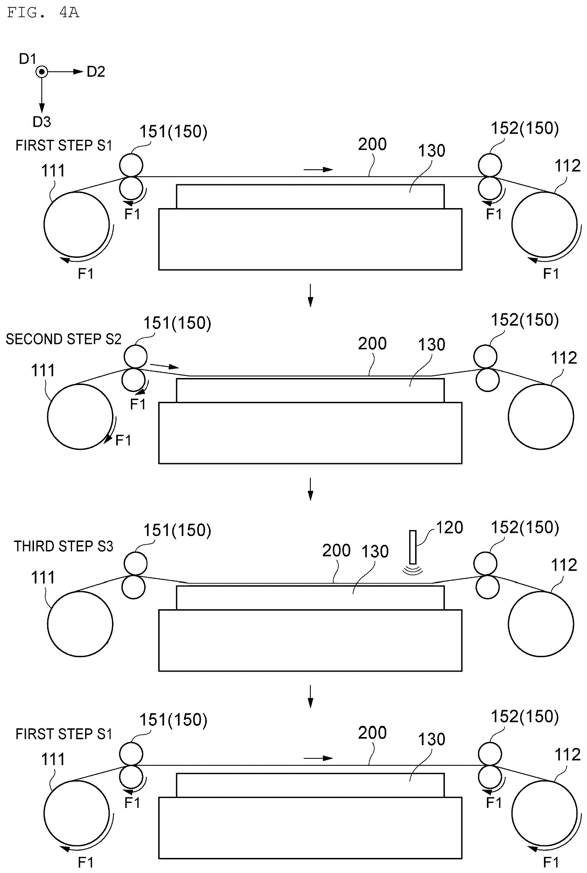

The control unit 140 repeatedly executes the first step S1, the second step S2, and the third step S3. FIG. 4A shows an aspect of a flow of the first step S1, the second step S2, and the third step S3. FIG. 4A is an outlined cross-sectional view on a plane formed by the longitudinal direction D2 and the height direction D3.

As shown in FIG. 4A, in the first step S1, the control unit 140 controls driving of the transfer mechanism 110 so as to transfer the metal plate 200 in the state where the metal plate 200 is not in contact with the stage 130. Specifically, the control unit 140 rotates, in a feed direction F1, the first roll 111 that feeds the metal plate 200 and the second roll 112 that rolls up the metal plate 200. The metal plate 200 is thereby transferred in the longitudinal direction D2.

As shown in FIG. 4A, the control unit 140 may rotate, in the feed direction F1, the first supplementary roll 151 and the second supplementary roll 152 that assist transfer of the metal plate 200. Note that in the example shown in FIG. 4A, the first supplementary roll 151 and the second supplementary roll 152 are rolls constituting the transfer mechanism 110 and are also rolls constituting the tension adjustment mechanism 150 which will be described later.

In the first step S1, the control unit 140 may exert control to adjust tension to be applied to the metal plate 200 between the first roll 111 and the second roll 112 by controlling a rotating speed of the first roll 111 and the second roll 112, thereby keeping the metal plate 200 from coming into contact with the stage 130 due to bending.

In the second step S2, the control unit 140 stops transfer of the metal plate 200 by means of the transfer mechanism 110 and brings the second surface 220 of the metal plate 200, transfer of which is stopped, into contact with the stage 130. Specifically, after stopping transfer of the metal plate 200, the control unit 140 may reduce tension on the metal plate 200 by means of the tension adjustment mechanism 150 which will be described later to bend the metal plate 200, so that the bent metal plate 200 comes into contact with the stage 130.

Instead of this or in addition to this, the metal plate 200 and the stage 130 may be relatively moved up/down in the height direction D3 by means of the lifting and lowering mechanism 160 such that the bent metal plate 200 comes into contact with the stage 130.

In the third step S3, the surface shape of the first surface 210 of the metal plate 200 is measured by the sensor 120 in the state where the second surface 220 of the metal plate 200 is in contact with the stage 130. Specifically, the control unit 140 may control driving of the first moving mechanism 121 and the second moving mechanism 122 to move the sensor 120 to an arbitrary position in the plane formed by the longitudinal direction D2 and the width direction D1. The sensor 120 may measure the height of the metal plate 200 at each place on the plane formed by the longitudinal direction D2 and the width direction D1 along with the movement, thereby obtaining the height profile.

Next, a hardware configuration of the control unit 140 will be described. The control unit 140 may be implemented by a microcontroller (MCU) or may be implemented by a general-purpose computer further including an input device such as a keyboard and an output device such as a display. In the case where the control unit 140 is a microcontroller, an information input/output device may be connected to an input/output interface of the microcontroller.

In particular, the control unit 140 may be electrically connected to the transfer mechanism 110, the sensor 120, the first moving mechanism 121, the second moving mechanism 122, the tension adjustment mechanism 150, and the lifting and lowering mechanism 160. For clearly expressing the diagram, FIG. 1 is expressed with components except connections with the control unit 140, the respective rolls constituting the transfer mechanism 110, the first moving mechanism 121, and the second moving mechanism 122 omitted. However, since the control unit 140 controls the measurement device 100, electrically-controlled constitutional mechanisms of the measurement device 100 may all be connected to the control unit 140 by wire or wirelessly even if there is no specific depiction. For example, although a connection between the sensor 120 and the control unit 140 is not expressed in the example of FIG. 1, it can be construed that the sensor 120 and the control unit 140 are connected with the first moving mechanism 121 and the second moving mechanism 122 interposed therebetween.

The measurement device 100 of the present disclosure may further have the tension adjustment mechanism 150. The tension adjustment mechanism 150 is not particularly restricted as long as it adjusts tension in the longitudinal direction D2 on the metal plate 200. At this time, in the first step S1, the control unit 140 may adjust the tension on the metal plate 200 by means of the tension adjustment mechanism 150 such that the metal plate 200 does not come into contact with the stage 130, thereby transferring the metal plate 200 by means of the transfer mechanism 110. Alternatively, the control unit 140 may stop transfer of the metal plate 200 and adjust the tension on the metal plate 200 by means of the tension adjustment mechanism 150 such that the metal plate 200 comes into contact with the stage 130.

FIG. 4A to FIG. 4D show an aspect of using the first supplementary roll 151 and the second supplementary roll 152 as an aspect of the tension adjustment mechanism 150. In the second step S2, the control unit 140 stops transfer of the metal plate 200 by means of the transfer mechanism 110 and brings the second surface 220 of the metal plate 200, transfer of which is stopped, into contact with the stage 130.

At this time, in the aspect shown in FIG. 4A, the control unit 140 slightly rotates the first roll 111 and the first supplementary roll 151 of the tension adjustment mechanism 150 in the feed direction F1 and stops them after stopping the transfer mechanism 110. On this occasion, the control unit 140 fixes the second supplementary roll 152 so as not to rotate. The metal plate 200 between the first supplementary roll 151 and the second supplementary roll 152 is thereby bent by a length fed by the first supplementary roll 151. The second surface 220 of the bent metal plate 200 comes into contact with the stage 130.

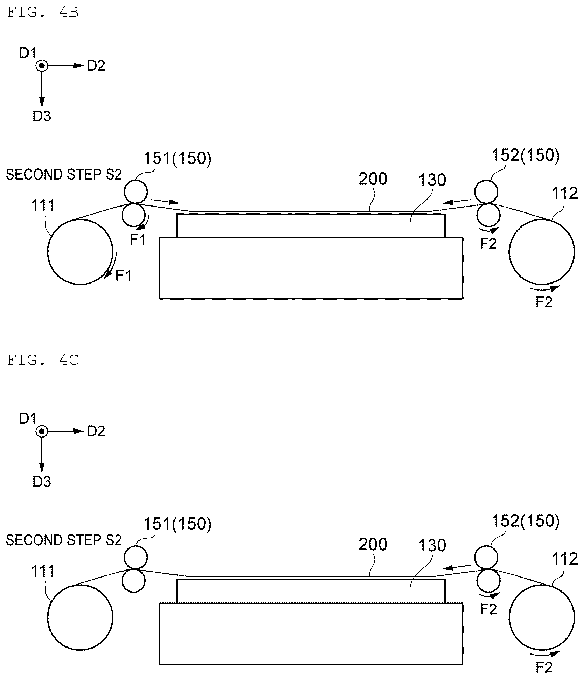

In the aspect shown in FIG. 4B, the control unit 140 slightly rotates the first roll 111 and the first supplementary roll 151 of the tension adjustment mechanism 150 in the feed direction F1 and stops them after stopping the transfer mechanism 110. The control unit 140 slightly rotates the second roll 112 and the second supplementary roll 152 of the tension adjustment mechanism 150 in a return direction F2 and stops them. The metal plate 200 between the first supplementary roll 151 and the second supplementary roll 152 is thereby bent by a length fed by the first supplementary roll 151 and the second supplementary roll 152. The second surface 220 of the bent metal plate 200 comes into contact with the stage 130.

In the aspect shown in FIG. 4C, the control unit 140 slightly rotates the second roll 112 and the second supplementary roll 152 of the tension adjustment mechanism 150 in the return direction F2 and stops them after stopping the transfer mechanism 110. On this occasion, the control unit 140 fixes the first supplementary roll 151 so as not to rotate. The metal plate 200 between the first supplementary roll 151 and the second supplementary roll 152 is thereby bent by a length fed by the second supplementary roll 152. The second surface 220 of the bent metal plate 200 comes into contact with the stage 130.

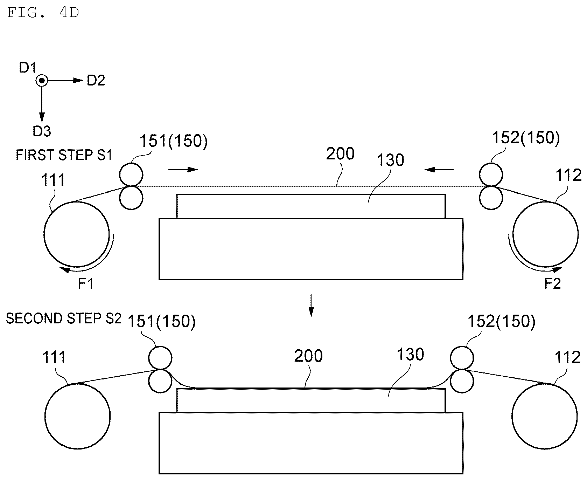

In the aspect shown in FIG. 4D, the distance between the first supplementary roll 151 and the second supplementary roll 152 is shortened to bend the metal plate 200 between the first supplementary roll 151 and the second supplementary roll 152. At this time, the first supplementary roll 151 and the second supplementary roll 152 may be brought closer to each other in a direction F3, or one of the first supplementary roll 151 and the second supplementary roll 152 may be brought closer to the other. Note that when the distance between the first supplementary roll 151 and the second supplementary roll 152 is shortened, the first roll 111 and the first supplementary roll 151 move away from each other. When the distance between the second supplementary roll 152 and the first supplementary roll 151 is shortened, the second roll 112 and the second supplementary roll 152 move away from each other. Thus, the first roll 111 and the second roll 112 may each be rotated. The second surface 220 of the metal plate 200 bent between the first supplementary roll 151 and the second supplementary roll 152 thereby comes into contact with the stage 130.

In any of the aspects in FIG. 4A to FIG. 4D, when transferring the metal plate 200 again after the third step S3, the control unit 140 may adjust the tension on the metal plate 200 again by the tension adjustment mechanism 150 such that the metal plate 200 does not come into contact with the stage 130 and may transfer the metal plate 200 by the transfer mechanism 110.

The device 100 for measuring a metal plate of the present disclosure may further have the lifting and lowering mechanism 160. The lifting and lowering mechanism 160 is not particularly restricted as long as it relatively lifts and lowers the transfer mechanism 110 relative to the stage 130. Specific examples of such a lifting and lowering mechanism 160 include a mechanism that lifts and lowers the stage 130.

At this time, in the first step S1, the control unit 140 may adjust an interval between the metal plate 200 and the transfer mechanism 110 in the height direction D3 by the lifting and lowering mechanism 160 such that the metal plate 200 does not come into contact with the stage 130, and may transfer the metal plate 200 by the transfer mechanism 110. The control unit 140 may stop transfer of the metal plate 200 and may adjust the positions of the metal plate 200 and the transfer mechanism 110 in the height direction D3 by the lifting and lowering mechanism 160 such that the metal plate 200 comes into contact with the stage 130.

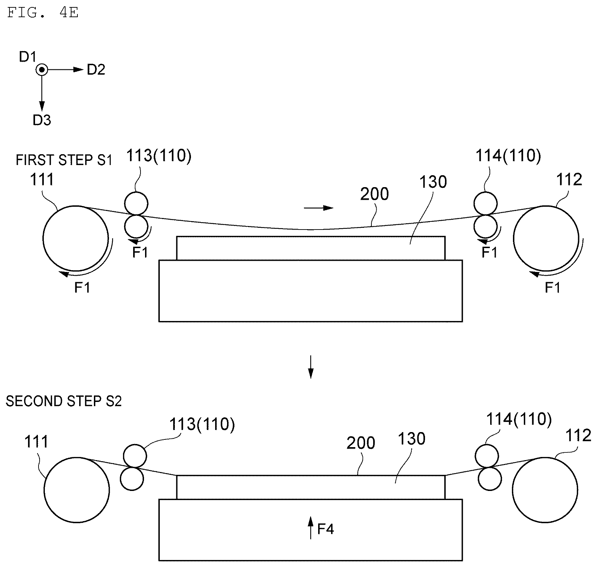

FIG. 4E shows an aspect of using a lifting and lowering machine 161 for the stage 130 as an aspect of the lifting and lowering mechanism 160. In the aspect shown in FIG. 4E, in the first step S1, the control unit 140 controls the transfer mechanism 110 so as to transfer the metal plate 200 in a bent state. In the second step S2, the control unit 140 stops transfer of the metal plate 200 by the transfer mechanism 110 and moves the position of the stage 130 by the lifting and lowering machine 161 in an upward direction F4 in the height direction D3 of the metal plate 200 and the transfer mechanism 110 such that the metal plate 200 comes into contact with the stage 130. The metal plate 200 in the bent state and the stage 130 thereby come into contact with each other.

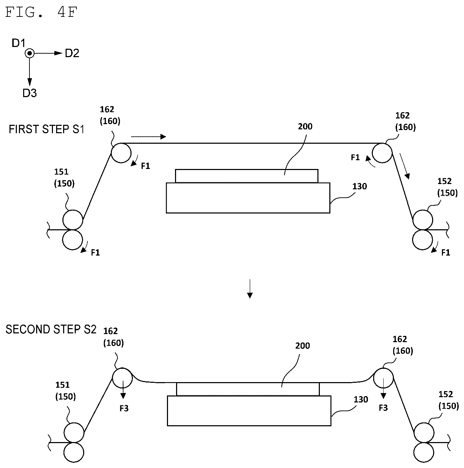

FIG. 4F shows an aspect of using lifting and lowering rollers 162 provided on sides of the stage 130 as an aspect of the lifting and lowering mechanism 160. In the aspect shown in FIG. 4F, in the first step S1, the control unit 140 controls the transfer mechanism 110 so as to transfer the metal plate 200 in a state where the lifting and lowering rollers 162 are positioned upward in the vertical direction. In the second step S2, the control unit 140 stops transfer of the metal plate 200 by the transfer mechanism 110 and pulls down the lifting and lowering rollers 162 downward in the vertical direction (F4'). The metal plate 200 is thereby bent by a distance that the lifting and lowering rollers 162 move down, and comes into contact with the stage 130.

The tension adjustment mechanism 150 and the lifting and lowering mechanism 160 described above may be used in combination. For example, the measurement device 100 of the present disclosure may have at least one of the tension adjustment mechanism 150 and the lifting and lowering mechanism 160. At this time, the control unit 140 may exert control so as to, in the first step S1, adjust the tension on the metal plate 200 and/or the interval between the metal plate 200 and the stage 130 by the tension adjustment mechanism 150 and/or the lifting and lowering mechanism 160 such that the metal plate 200 does not come into contact with the stage 130 and transfer the metal plate 200 by the transfer mechanism 110, and in the third step S3, stop transfer of the metal plate 200, adjust the tension on the metal plate 200 and/or the interval between the metal plate 200 and the stage 130 by the tension adjustment mechanism 150 and/or the lifting and lowering mechanism 160 such that the metal plate 200 comes into contact with the stage 130, and measure the surface shape of the first surface 210 of the metal plate 200 by the sensor 120.

Subsequently, the method for measuring the metal plate will be described. The method for measuring the metal plate of the present disclosure repeatedly executes the first step S1, the second step S2, and the third step S3 using the above-described measurement device. This enables the surface shape of the metal plate to be continuously measured in a wider range. Since it is unnecessary to measure a measurement sample cut from the metal plate in the sheet form unlike the conventional device, the influence of distortion of the metal plate caused by cutting can be eliminated.

Note that hereinafter, an operation of repeating transfer and stop of the metal plate 200 will also be referred to as an intermittent operation.

FIG. 5 shows a flowchart representing an aspect of the method for measuring the metal plate. As shown in FIG. 5, in the method for measuring the metal plate of the present disclosure, the metal plate 200 is transferred by the transfer mechanism 110 in the first step S1 in the state where the metal plate 200 is not in contact with the stage 130.

At this time, the transfer mechanism 110 may execute the intermittent operation of transferring the metal plate 200 in the longitudinal direction D2 by a distance of one stage 130 or less. The surface shape in a range continuous in the longitudinal direction D2 can thereby be measured.

Alternatively, the transfer mechanism 110 may execute the intermittent operation of transferring the metal plate 200 in the longitudinal direction D2 by a distance larger than one stage 130. The surface shape in a range not continuous in the longitudinal direction D2 can thereby be measured. For example, the surface shape of the elongated metal plate 200 can be measured every 5 m by executing the intermittent operation of repeating transfer and stop every 5 m.

In the method for measuring the metal plate of the present disclosure, in the second step S2, transfer of the metal plate 200 is stopped, and the second surface 220 of the metal plate 200, transfer of which is stopped, is brought into contact with the stage 130.

At this time, the second surface 220 of the metal plate 200 is brought into contact with the stage 130 using the tension adjustment mechanism 150 or the lifting and lowering mechanism 160 as described above (see FIG. 4A to FIG. 4E). In the present disclosure, it is preferable to measure the surface shape in a state where no tension is applied to the metal plate 200. This can eliminate the influence on the measurement of the surface shape caused by the tension applied by the transfer mechanism 110. Therefore, in the second step S2, it is preferable to bring the second surface 220 of the metal plate 200 in the bent state into contact with the stage 130.

In the third step S3, the surface shape of the first surface 210 of the metal plate 200 is measured by the sensor 120 in the state where the second surface 220 of the metal plate 200 is in contact with the stage 130. Measurement pitches in the longitudinal direction D2 and the width direction D1 are not particularly limited and can be determined as appropriate depending on a desired measurement accuracy, and may be 1 to 50 mm, may be 1 to 40 mm, may be 1 to 30 mm, or may be 1 to 20 mm, for example.

In the fourth step S4, the control unit 140 confirms whether a preset range has been measured, and when measurement of the preset range has been finished, terminates the measuring operation. When the measurement of the preset range has not been finished, the first step S1 to the third step S3 may further be repeated.

Next, a method for manufacturing a metal plate to be used for manufacturing a metal mask will be described. The method for manufacturing a metal plate of the present disclosure includes a rolling step of rolling a base material to obtain a metal plate and an inspection step of inspecting the metal plate obtained by rolling. In the inspection step, the first step S1, the second step S2, and the third step S3 are repeatedly executed using the above-described measurement device.

The method for manufacturing a metal plate of the present disclosure may further include, after the rolling step and before the inspection step, a slitting step of cutting off ends in the width direction of the metal plate obtained by rolling and an annealing step of annealing the metal plate obtained by rolling.

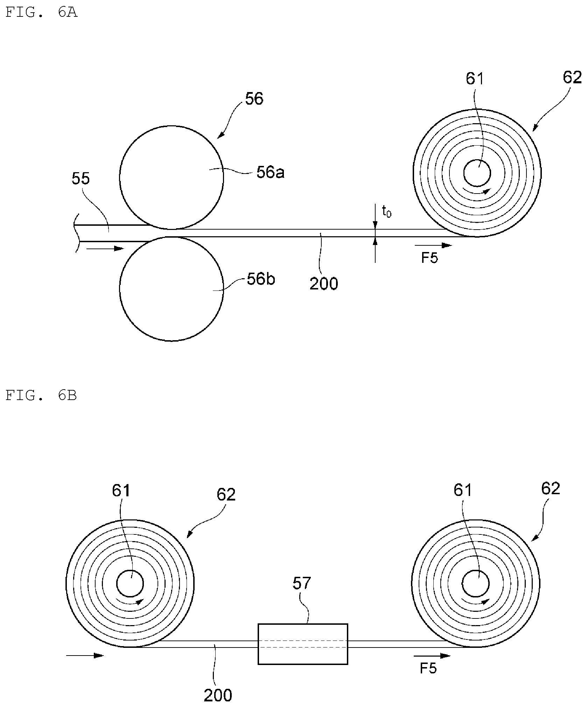

FIG. 6A is an outlined cross-sectional view showing an aspect of the rolling step. In the rolling step, a base material 55 is rolled to obtain a metal plate having a desired thickness. The base material 55 may be made of an invar material, for example.

In the rolling step, the base material 55 is transferred toward a rolling device 56 including a pair of rolling rolls 56a, 56b in the transfer direction indicated by an arrow F5. The base material 55 arrived at a position between the pair of rolling rolls 56a, 56b is rolled by the pair of rolling rolls 56a, 56b. As a result, the base material 55 is reduced in thickness and extended in the transfer direction. The metal plate 200 which is thin and elongated can thereby be obtained. As shown in FIG. 6A, the metal plate 200 may be rolled up around a core 61 to form a rolled body 62.

A thickness of the metal plate 200 may be, for example, 5 µm or more, may be 10 µm or more, may be 15 µm or more, may be 20 µm or more, or may be 25 µm or more. The thickness of the metal plate 200 may be, for example, 100 µm or less, may be 80 µm or less, may be 60 µm or less, may be 50 µm or less, or may be 40 µm or less. The thickness of the metal plate 200 may be, for example, 5 to 100 µm, may be 10 to 80 µm, may be 15 to 60 µm, may be 20 to 50 µm, or may be 25 to 40 µm.

A weight of the metal plate 200 preferably may be 0.005 g/cm² or more, may be 0.010 g/cm² or more, may be 0.015 g/cm² or more, may be 0.020 g/cm² or more, may be 0.025 g/cm² or more, or may be 0.030 g/cm² or more. The weight of the metal plate 200 preferably may be 0.070 g/cm² or less, may be 0.060 g/cm² or less, or may be 0.050 g/cm² or less.

As the thickness of the metal plate 200 is smaller, the weight of the metal plate 200 per unit area is lighter. This leads to a tendency that air between the stage 130 and the metal plate 200 is difficult to escape when the stage 130 and the metal plate 200 come into contact with each other. Consequently, in a case where the thickness of the metal plate 200 falls within the above-described range, it is preferable that the stage 130 should have holes or grooves in the surface with which the metal plate comes into contact.

Note that FIG. 6A merely shows an outline of the rolling step, and a specific configuration and procedure for carrying out the rolling step are not particularly limited. For example, the rolling step may include a hot-rolling step of processing the base material at a temperature of or above a recrystallization temperature of the invar material constituting the base material 55 or a cold-rolling step of processing the base material at a temperature of or below the recrystallization temperature of the invar material.

The slitting step is a step of cutting off ends in the width direction of the metal plate obtained by rolling. By cutting off both the ends in the width direction D1 of the metal plate 200 by this slitting step, cracks that may occur at both the ends can be eliminated. Breakage of the metal plate 200 resulting from the cracks is thereby further reduced. Ranges to be cut off are not particularly limited and may each fall within a range of 3 to 5 mm, for example.

FIG. 6B is an outlined cross-sectional view showing an aspect of the annealing step. In the annealing step, the metal plate obtained by rolling is annealed by an annealing device 57. A residual stress accumulated in the metal plate 200 can thereby be removed. In the annealing step, the metal plate 200 may be continuously annealed while being transferred in a direction F5 as shown in FIG. 6B. Instead of this, annealing may be performed in a batch process. Treatment conditions of the annealing step can be set as appropriate in accordance with the thickness, rolling rate, and the like of the metal plate 200. For example, the treatment conditions of the annealing step may be set at 500°C and 60 seconds.

The rolling step, the slitting step, and the annealing step may be repeated a plurality of times. The metal plate 200 having a desired thickness can be obtained by repeating these steps.

In the inspection step, the metal plate obtained by rolling is inspected. The metal plate 200 to be inspected in the inspection step may have undergone the rolling step, the slitting step, and the annealing step once or repeatedly by a plurality of times. An inspection method in the inspection step is substantially identical to the aforementioned method for measuring a metal plate, details of which will thus be omitted.

The method for manufacturing a metal mask of the present disclosure includes a step of preparing a metal plate, a resist pattern forming step of forming a resist pattern on the metal plate, and an etching step of etching a region of the metal plate which is not covered by the resist pattern to form, in the metal plate, recesses to serve to define through-holes, thereby manufacturing a metal mask in which a plurality of through-holes are formed.

The metal mask of the present disclosure can be used for various applications. Although not particularly limited, the metal mask of the present invention can be used as, for example, a metal mask to be used for patterning an organic material on a substrate in a desired pattern in manufacturing of an organic EL display device. The metal mask of the present disclosure enables patterning at a high pixel density. Organic EL display devices that can be manufactured include not only displays of a smartphone, a television, and the like, but also devices for displaying or projecting an image or video for expressing virtual reality (VR) or augmented reality (AR).

Note that in the present specification and the present drawings, an example of a metal mask to be used when manufacturing an organic EL display device, and a method for manufacturing the metal mask will be described as one embodiment of the present invention unless otherwise specified.

The method for manufacturing the metal mask according to one embodiment of the present disclosure includes a preparation step of preparing the metal plate 200 having the first surface 210 and the second surface 220 positioned opposite to the first surface 210, and an etching step of etching the metal plate 200 to form the above-described metal mask 20.

Note that although a method for manufacturing the metal mask 20 by etching will be described below, the metal mask 20 may be formed by either etching or laser machining.

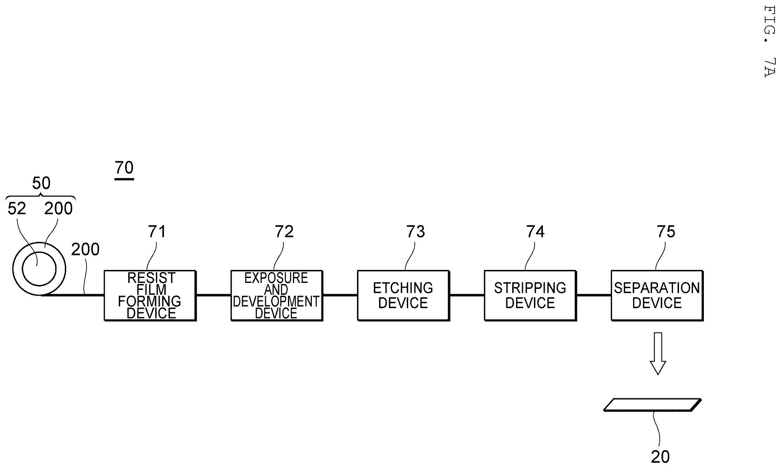

The method for manufacturing the metal mask 20 according to one embodiment of the present disclosure will be described mainly with reference to FIG. 7A to FIG. 7F. FIG. 7A is an outlined view showing a manufacturing apparatus 70 for manufacturing the metal mask 20 using the metal plate 200 together with its processing order. FIG. 7A shows an example in which the metal plate 200 is supplied continuously from a resist film forming device 71 to a stripping device 74. However, the method for manufacturing the metal mask 20 of the present disclosure is not limited to this, and, for example, the metal plate 200 may be rolled up each time it undergoes processing by each of the devices to be brought into a state of a rolled-up body. When the metal plate 200 is supplied to each of the devices, the metal plate 200 may be pulled out from the rolled-up body and supplied.

Hereinafter, each step of the method for manufacturing the metal mask 20 will be described in detail.

First, the metal plate 200 having a desired thickness is prepared (the preparation step). The metal plate 200 may be in the state of a rolled body 50. The method for fabricating the metal plate 200 having a desired thickness can include, for example, but is not particularly limited to, the above-described rolling method, a plating deposition method, or the like.

In the method for manufacturing a metal mask of the present disclosure, a surface shape of a first surface of the metal plate is measured in the step of preparing a metal plate. The measuring method is substantially identical to the aforementioned method for measuring a metal plate, details of which will thus be omitted.

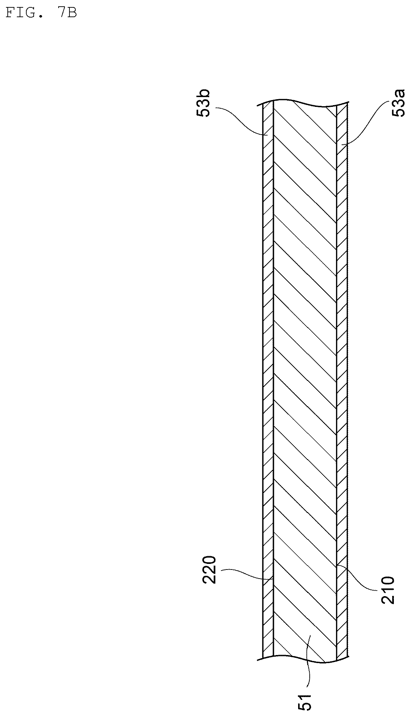

Subsequently, the resist films 53a and 53b are formed on the first surface 210 and the second surface 220 of the metal plate 200 using the resist film forming device 71 (FIG. 7B). Specifically, the resist films 53a and 53b may be formed by bonding a dry film resist to the first surface 210 and the second surface 220. Alternatively, the resist films 53a and 53b may be formed by coating the first surface 210 and the second surface 220 with a coating liquid containing a photosensitive resist material and drying the first surface 210 and the second surface 220.

The dry film resist and the coating liquid are not particularly limited, and conventionally known ones can be used. The resist films 53a and 53b thus formed may be either a negative type resist or a positive type resist. Between them, the negative type resist is preferably used.

The thickness of the resist films 53a and 53b may be 15 µm or less, may be 10 µm or less, may be 6 µm or less, or may be 4 µm or less. The thickness of the resist films 53a and 53b may be 1 µm or more, may be 3 µm or more, may be 5 µm or more, or may be 7 µm or more. The range of the thickness of the resist films 53a and 53b may be determined by a combination of an arbitrary one of the above-described plurality of upper-limit candidate values and an arbitrary one of the above-described plurality of lower-limit candidate values.

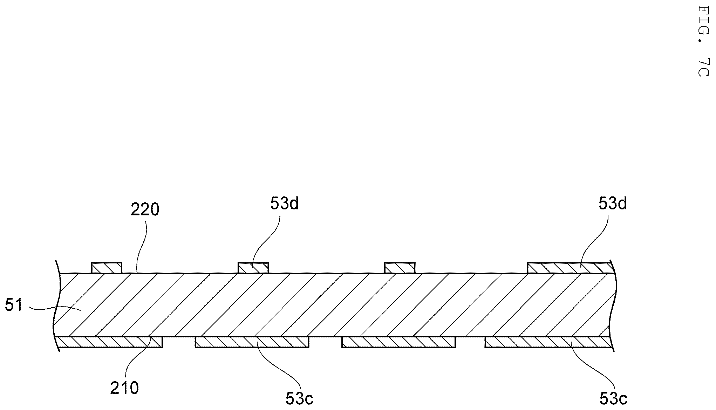

Subsequently, the resist films 53a and 53b are exposed and developed using an exposure and development device 72. This enables a first resist pattern 53c to be formed on the first surface 210 and a second resist pattern 53d to be formed on the second surface 220 as shown in FIG. 7C. In the case where a negative type resist film is used, for example, a photomask configured so as not to let light pass through a to-be-removed region of the resist film may be arranged on the resist film, so that the resist film may be exposed through the photomask, and the resist film may further be developed.

Subsequently, an etching device 73 is used to etch the metal plate 200 using the first resist pattern 53c and the second resist pattern 53d as masks (the etching step). The etching step may include the first surface etching step and the second surface etching step.

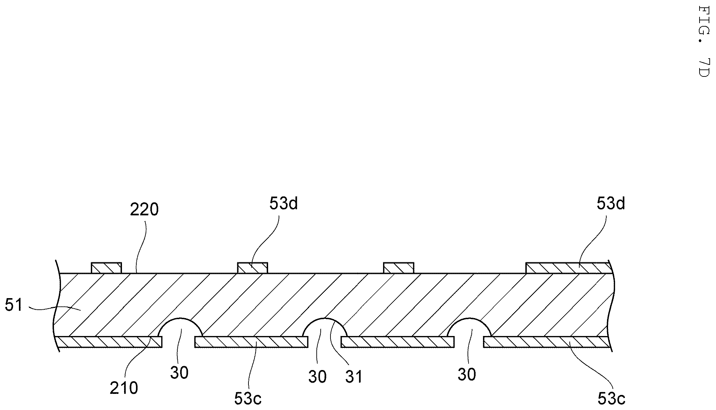

FIG. 7D shows an outlined view representing an example of the first surface etching step in the perforated region 22. In the first surface etching step, regions of the first surface 210 which are not covered by the first resist pattern 53c are etched using an etching solution. On this occasion, the second surface 220 may be covered by resin or the like resistant to the etching solution.

Erosion by the etching solution progresses in the regions of the first surface 210 which are not covered by the first resist pattern 53c (FIG. 7D). A large number of the first recesses 30 are thereby formed in the first surface 210. Note that etching of the metal plate 200 may progress isotropically in various directions from holes of the resist pattern. Thus, the first recess 30 and the second recess 35 are shaped such that their cross sectional areas at each position in the thickness direction of the metal mask 20 gradually decrease with progress in the thickness direction from the surfaces.

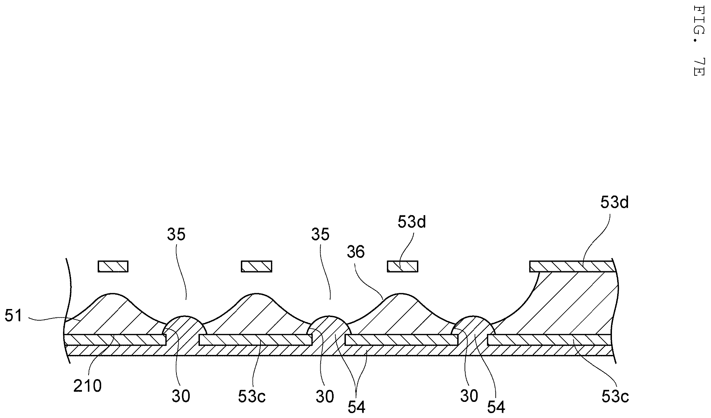

FIG. 7E shows an outlined view representing an example of the second surface etching step in the perforated region 22. In the second surface etching step, the regions of the second surface 220 which are not covered by the second resist pattern 53d are etched using the etching solution. On this occasion, the film or the like covering the second surface 220 in the first surface etching step may be stripped in advance. The first surface 210 may be covered by a resin 54 or the like resistant to the etching solution.

Erosion by the etching solution progresses in the regions of the second surface 220 which are not covered by the second resist pattern 53d (FIG. 7E). The second recesses 35 are thereby formed in the second surface 220. The first recess 30 and the second recess 35 then communicate with each other, thereby forming the through-hole 25.

The etching solution is not particularly limited as long as it is conventionally known, and examples thereof can include a solution containing a ferric chloride solution and hydrochloric acid.

In the second surface etching step, etching may progress until adjacent ones of the second recesses 35 are connected to each other as shown in FIG. 7E. At a location where adjacent ones of the second recesses 35 are connected to each other, the adjacent ones of the second recesses 35 join to form the ridge line 36. The ridge line 36 is spaced from the second resist pattern 53d, and erosion by etching also progresses in the thickness direction of the metal plate 200 at a top of the ridge line 36. The second resist pattern 53d is thereby stripped from the metal plate 200. Note that the second surface 220 may be partially left between adjacent ones of the second recesses 35.

Furthermore, the resist patterns and the resin 54 or the like resistant to the etching solution are stripped from the metal plate 200 using the stripping device 74. Then, a separation step of cutting the elongated metal plate 200 using a separation device 75, thereby separating the metal mask 20 formed of a sheet-like metal plate from the metal plate 200 is performed. The metal mask 20 can be obtained in this manner.

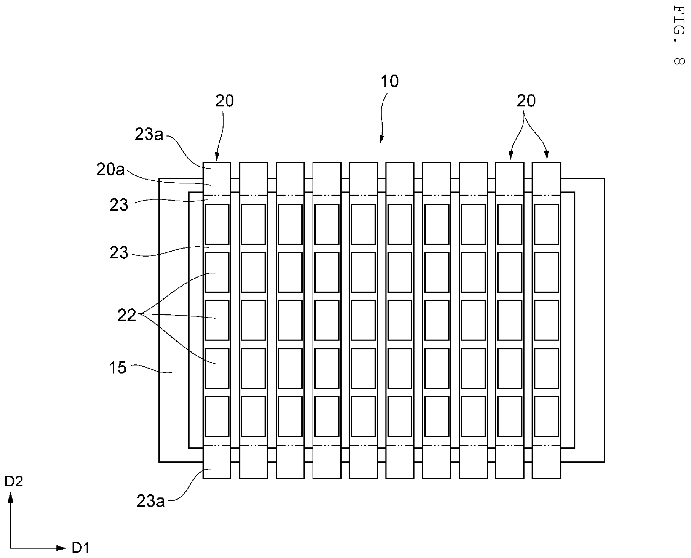

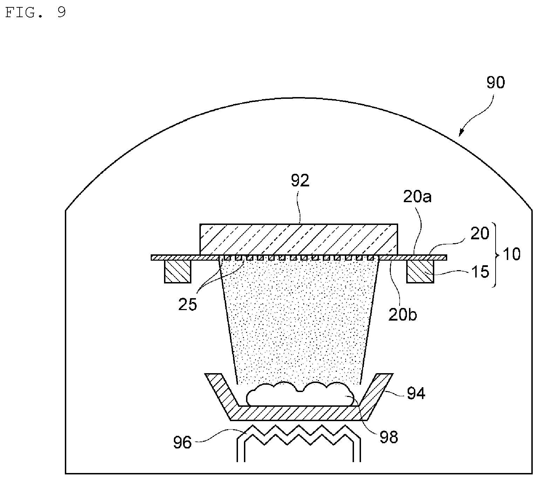

The metal mask device 10 according to one embodiment of the present disclosure includes the frame 15 and the above-described metal mask 20 installed on the frame 15. The metal mask 20 may be installed on the frame 15 with the second surface 20b in contact with the frame 15. FIG. 8 shows a plan view of the metal mask device 10 as seen from the first surface 20a side of the metal mask 20. FIG. 9 shows a cross-sectional view representing the vapor deposition device.

In the metal mask device 10 of the present disclosure, a plurality of the metal masks 20 may be attached to one frame (FIG. 8). In this case, the plurality of metal masks 20 may be aligned in the width direction crossing the longitudinal direction of the metal mask 20. Each of the metal masks 20 may be fixed to the frame 15 at both end portions 23a in the longitudinal direction of the metal mask 20 in a peripheral region 23 that surrounds the perforated regions 22.

A method for fixing the metal masks 20 to the frame 15 can include, for example, but is not particularly limited to, welding and the like.

The metal mask device 10 may include a member fixed to the frame 15 and partially overlapped on the metal masks 20 in the thickness direction of the metal masks 20. Such a member can include, for example, but is not particularly limited to, a member extending in the direction crossing the longitudinal direction of the metal masks 20 and supporting the metal masks 20, a member overlapped on a gap between adjacent two metal masks, and the like.

Next, a method for manufacturing an organic EL display device using the metal mask 20 according to the present disclosure will be described with reference to FIG. 9. The organic EL display device may include, in a stacked state, the substrate 92 and a vapor deposition layer including the vapor deposition material 98 provided in a pattern shape.

The method for manufacturing the organic EL display device of one embodiment of the present disclosure can include, for example, but is not particularly limited to, a vapor deposition step of vapor-depositing the vapor deposition material 98 on a substrate such as the substrate 92 using the metal mask 20.

In the vapor deposition step, the metal mask device 10 is arranged first such that the metal mask 20 is opposed to the substrate 92. On this occasion, the first surface 20a of the metal mask 20 may be opposed to the substrate 92 as shown in FIG. 9. Herein, the substrate 92 is an evaporation target such as a glass substrate.

In a case where the metal mask device 10 is stored in the vapor deposition device 90 as shown in FIG. 9, a surface of the metal mask 20 facing the substrate 92 is the first surface 20a, and a surface of the metal mask 20 positioned on the crucible 94 side that holds the vapor deposition material 98 is the second surface 20b. In the vapor deposition device 90, the metal mask 20 is located on a surface of the substrate 92 on the crucible 94 side. Herein, the metal mask 20 and the substrate 92 may be brought into close contact with each other by a magnetic force.

In the vapor deposition device 90, the crucible 94 that stores the vapor deposition material 98 and a heater 96 that heats the crucible 94 may be arranged below the metal mask device 10. Herein, the vapor deposition material 98 may be an organic light emitting material as an example. The vapor deposition material 98 in the crucible 94 is vaporized or sublimated by heating of the heater 96. The vaporized or sublimated vapor deposition material 98 adheres to the substrate 92 by way of the through-holes 25 of the metal mask 20. The vapor deposition material 98 is thereby deposited on the surface of the substrate 92 in a desired pattern corresponding to the position of the through-holes 25 of the metal mask 20. Note that in the vapor deposition step, the inside of the vapor deposition device 90 may be brought into a vacuum atmosphere.

In a case of intending to vapor-deposit different types of vapor deposition materials in accordance with pixels such as RGB, the vapor deposition material 98 may be deposited on the surface of the substrate 92 using different metal masks 20 in accordance with colors of the vapor deposition material 98. For example, the vapor deposition material 98 for red, the vapor deposition material 98 for green, and the vapor deposition material 98 for blue may be sequentially deposited on the substrate 92. Alternatively, the metal mask 20 (the metal mask device 10) and the substrate 92 may be relatively moved little by little in an array direction (the aforementioned one direction) of the through-holes 25 to sequentially deposit the vapor deposition material 98 for red, the vapor deposition material 98 for green, and the vapor deposition material 98 for blue.

The method for manufacturing the organic EL display device may include various steps in addition to the vapor deposition step of vapor-depositing the vapor deposition material 98 on the substrate such as the substrate 92 using the metal mask 20. For example, the method for manufacturing the organic EL display device may include a step of forming a first electrode on the substrate. The vapor deposition layer is formed on the first electrode. The method for manufacturing the organic EL display device may also include a step of forming a second electrode on the vapor deposition layer. The method for manufacturing the organic EL display device may also include a sealing step of sealing the first electrode, the vapor deposition layer, and the second electrode provided on the substrate 92.

The vapor deposition layer formed on the substrate such as the substrate 92 using the metal mask 20 is not limited to the light emitting layer formed by vapor deposition of the above-described organic light emitting material, and may include other layers. For example, the vapor deposition layer may include a hole injection layer, a hole transport layer, a light emitting layer, an electron transport layer, an electron injection layer, and the like in this order from the first electrode side. In this case, the vapor deposition step through use of the metal mask 20 corresponding to each of the layers may be performed.

The method for continuously measuring the surface shape of the elongated metal plate in a wide range has been described above. As a modification thereof, the device for measuring a metal plate according to one embodiment of the present disclosure may be used for measurement of a metal plate in a sheet form. The device for measuring a metal plate on this occasion may be configured similarly to the above-described device except that the transfer mechanism is not provided.

Specifically, a device for measuring a metal plate in the sheet form includes a sensor that measures the surface shape of a first surface of the metal plate, a stage with which a second surface of the metal plate positioned opposite to the first surface comes into contact during measurement by the sensor, and a control unit that executes a measuring step equivalent to the third step. The measuring step is a step of measuring the surface shape of the first surface of the metal plate by the sensor in a state where the second surface of the metal plate is in contact with the stage. The stage has holes or grooves in a surface with which the metal plate comes into contact.

Also in the device for measuring a metal plate in the sheet form, the presence of the holes or grooves in the stage 130 facilitates reduction of vibration of the metal plate 200 when the stage 130 and the metal plate 200 come into contact with each other similarly to the above-described device, which leads to a tendency that the measurement accuracy is further improved.

### Industrial Applicability

The present invention has industrial applicability as a device to be used for inspecting a metal plate or the like to be used for manufacturing a metal mask.

### Reference Signs List

- 10: metal mask device
- 15: frame
- 20: metal mask
- 20a: first surface
- 20b: second surface
- 22: perforated region
- 23: peripheral region
- 23a: both end portions
- 25: through-hole
- 30: first recess
- 31: first wall surface
- 35: second recess
- 36: ridge line
- 50: rolled body
- 53a: resist film
- 53b: resist film
- 53c: first resist pattern
- 53d: second resist pattern
- 54: resin
- 55: base material
- 56: rolling device
- 56a: rolling roll
- 56b: rolling roll
- 61: core
- 62: rolled body
- 70: manufacturing apparatus
- 71: resist film forming device
- 72: exposure and development device
- 73: etching device
- 74: stripping device
- 75: separation device
- 90: vapor deposition device
- 92: substrate
- 96: heater
- 98: vapor deposition material
- 100: measurement device
- 110: transfer mechanism
- 111: first roll
- 112: second roll
- 120: sensor
- 121: first moving mechanism
- 122: second moving mechanism
- 130: stage
- 140: control unit
- 150: tension adjustment mechanism
- 151: first supplementary roll
- 152: second supplementary roll
- 160: lifting and lowering mechanism
- 161: lifting and lowering machine
- 200: metal plate
- 210: first surface
- 220: second surface

## Claims

1. A device for measuring a metal plate, the device comprising:
a transfer mechanism that transfers the metal plate in a longitudinal direction D2;
a sensor that measures a surface shape of a first surface of the metal plate;
a stage with which a second surface of the metal plate positioned opposite to the first surface comes into contact during measurement by the sensor; and
a control unit that repeatedly executes a first step, a second step, and a third step, wherein
in the first step, the metal plate is transferred by the transfer mechanism in a state where the metal plate is not in contact with the stage,
in the second step, transfer of the metal plate is stopped, and the second surface of the metal plate, transfer of which is stopped, is brought into contact with the stage,
in the third step, the surface shape of the first surface of the metal plate is measured by the sensor in a state where the second surface of the metal plate is in contact with the stage, and
the stage has a hole or a groove in a surface with which the metal plate comes into contact.

2. The device according to claim 1, further comprising a tension adjustment mechanism that adjusts tension on the metal plate in the longitudinal direction D2, wherein
the control unit exerts control so as to
in the first step, adjust the tension on the metal plate by the tension adjustment mechanism such that the metal plate does not come into contact with the stage and transfer the metal plate by the transfer mechanism,
in the third step, stop transfer of the metal plate, adjust the tension on the metal plate by the tension adjustment mechanism such that the metal plate comes into contact with the stage, and measure the surface shape of the first surface of the metal plate by the sensor.

3. The device according to claim 1, further comprising a lifting and lowering mechanism that relatively lifts and lowers the transfer mechanism relative to the stage, wherein
the control unit exerts control so as to
in the first step, adjust an interval between the metal plate and the stage by the lifting and lowering mechanism such that the metal plate and the stage do not come into contact with each other and transfer the metal plate by the transfer mechanism, and
in the third step, stop transfer of the metal plate, adjust the interval between the metal plate and the stage by the lifting and lowering mechanism such that the metal plate and the stage come into contact with each other, and measure the surface shape of the first surface of the metal plate by the sensor.

4. The device according to claim 1, further comprising at least one of a tension adjustment mechanism that adjusts tension on the metal plate in the longitudinal direction D2 and a lifting and lowering mechanism that relatively lifts and lowers the transfer mechanism relative to the stage, wherein
the control unit exerts control so as to
in the first step, adjust the tension on the metal plate and/or the interval between the metal plate and the stage by the tension adjustment mechanism and/or the lifting and lowering mechanism such that the metal plate does not come into contact with the stage and transfer the metal plate by the transfer mechanism, and
in the third step, stop transfer of the metal plate, adjust the tension on the metal plate and/or the interval between the metal plate and the stage by the tension adjustment mechanism and/or the lifting and lowering mechanism such that the metal plate comes into contact with the stage, and measure the surface shape of the first surface of the metal plate by the sensor.

5. The device according to claim 1, wherein the metal plate has a thickness of 5 to 100 µm.

6. The device according to claim 1, wherein a contactable area is 80% to 99%.

7. The device according to claim 1, wherein the transfer mechanism has a first roll that feeds the metal plate and a second roll that rolls up the metal plate.

8. A method for measuring a metal plate, which is performed using a measurement device including
a transfer mechanism that transfers the metal plate in a longitudinal direction D2,
a sensor that measures a surface shape of a first surface of the metal plate,
a stage with which a second surface of the metal plate positioned opposite to the first surface comes into contact during measurement by the sensor, and
a control unit that repeatedly executes a first step, a second step, and a third step, wherein
in the first step, the metal plate is transferred by the transfer mechanism in a state where the metal plate is not in contact with the stage,
in the second step, transfer of the metal plate is stopped, and the second surface of the metal plate, transfer of which is stopped, is brought into contact with the stage,
in the third step, the surface shape of the first surface of the metal plate is measured by the sensor in a state where the second surface of the metal plate is in contact with the stage, and
the stage has a hole or a groove in a surface with which the metal plate comes into contact.

9. A method for manufacturing a metal plate to be used for manufacturing a metal mask, the method comprising:
a rolling step of rolling a base material to obtain the metal plate; and
an inspection step of inspecting the metal plate having been rolled, wherein
the inspection step is performed using a measurement device including
a transfer mechanism that transfers the metal plate in a longitudinal direction D2,
a sensor that measures a surface shape of a first surface of the metal plate,
a stage with which a second surface of the metal plate positioned opposite to the first surface comes into contact during measurement by the sensor, and
a control unit that repeatedly executes a first step, a second step, and a third step,
in the first step, the metal plate is transferred by the transfer mechanism in a state where the metal plate is not in contact with the stage,
in the second step, transfer of the metal plate is stopped, and the second surface of the metal plate, transfer of which is stopped, is brought into contact with the stage,
in the third step, the surface shape of the first surface of the metal plate is measured by the sensor in a state where the second surface of the metal plate is in contact with the stage, and
the stage has a hole or a groove in a surface with which the metal plate comes into contact.

10. A method for manufacturing a metal mask in which a plurality of through-holes are formed, the method comprising:
a step of preparing a metal plate;
a resist pattern forming step of forming a resist pattern on the metal plate; and
an etching step of etching a region of the metal plate which is not covered by the resist pattern to form, in the metal plate, recesses to serve to define the through-holes, wherein
the step of preparing a metal plate is performed using a measurement device including
a transfer mechanism that transfers the metal plate in a longitudinal direction D2,
a sensor that measures a surface shape of a first surface of the metal plate,
a stage with which a second surface of the metal plate positioned opposite to the first surface comes into contact during measurement by the sensor, and
a control unit that repeatedly executes a first step, a second step, and a third step,
in the first step, the metal plate is transferred by the transfer mechanism in a state where the metal plate is not in contact with the stage,
in the second step, transfer of the metal plate is stopped, and the second surface of the metal plate, transfer of which is stopped, is brought into contact with the stage,
in the third step, the surface shape of the first surface of the metal plate is measured by the sensor in a state where the second surface of the metal plate is in contact with the stage, and
the stage has a hole or a groove in a surface with which the metal plate comes into contact.
